# FASCICULE DE BREVET EUROPEEN

(11) **EP 0 828 260 B1**
(45) Date de publication et mention de la délivrance du brevet: **12.07.2000**
(21) Numéro de dépôt: 97402041.4
(22) Date de dépôt: 02.09.1997
(51) Int. Cl.: H01C 10/32, H01C 17/065

(54) **Procédé de réalisation d'un circuit de réglage asservi de la position d'un organe mobile, notamment dans un correcteur de l'orientation du faisceau d'un projecteur de véhicule automobile, et circuit de réglage asservi**
Steuerkreislauf für die Positionierung eines beweglichen Organs, insbesondere verwendet in einer Steuerungseinrichtung zur Neigung eines Fahrzeugscheinwerfers, und Verfahren zur Herstellung
Control circuit for positioning a mobile element, in particular used in a device controlling the inclination of a vehicle headlamp, and method of fabrication thereof

(30) Priorité: 03.09.1996 FR 9610714
(43) Date de publication de la demande: 11.03.1998
(73) Titulaire: VALEO VISION, 93000 Bobigny (FR)
(72) Inventeur: Metayer, Guy, 92150 Suresnes (FR); Bazard, Sébastien, 75010 Paris (FR)
(74) Mandataire: Le Forestier, Eric

(56) Documents cités:
- EP-A- 0 466 539
- EP-A- 0 509 420
- US-A- 4 500 866
- US-A- 5 051 719
- "Silk-screening prints conductors, resistors on circuit boards" ELECTRONICS, vol. 47, no. 15, 25 juin 1974, pages 33-34, XP002031025

## Description

La présente invention a trait d'une façon générale aux dispositifs de réglage asservi de la position d'un organe mobile. En particulier, elle concerne un dispositif de réglage de l'orientation du faisceau lumineux émis par un projecteur de véhicule automobile, ainsi qu'un procédé de fabrication du circuit électrique d'un tel dispositif.

De façon classique, un tel dispositif est logé dans le projecteur et comporte une tige de commande mobile en rotation et/ou en translation, commandée par un moto-réducteur et agissant sur un point de réglage du miroir du projecteur.

Un circuit électronique associé reçoit un signal de consigne désignant une position angulaire dans laquelle doit être amenée la tige, ladite position pouvant varier continûment ou pratiquement continûment dans un intervalle donné.

L'information indiquant la position courante du curseur, et permettant donc de déterminer si la position demandée a bien été atteinte, est obtenue à l'aide d'un potentiomètre du commerce, rapporté sur la carte électronique du correcteur et dont le curseur est mobile avec la tige de commande pour se déplacer le long de la piste résistive continue du potentiomètre.

Un circuit de commande asservie de position est associé à ce mécanisme à curseur.

De façon classique, le curseur se déplace sur deux pistes, à savoir la piste résistive précitée, dont le potentiel varie par conséquent de façon continue sur sa trajectoire, et une seconde piste continue, en contact essentiellement non résistif avec le curseur, pour recueillir le potentiel prélevé sur l'autre piste.

Au moins cette seconde piste est constituée conventionnellement par une zone métallisée qui a été revêtue de nickel ou d'or afin d'accroître sa résistance à l'abrasion et d'assurer de façon durable un contact électrique essentiellement non résistif avec le curseur.

Un inconvénient majeur d'un tel dispositif connu réside dans la la nécessité de prévoir un potentiomètre rapporté dans le correcteur, ce qui accroît le coût de revient (pièces et temps de montage) du correcteur.

Un autre inconvénient réside en ce que la courbe de réponse du potentiomètre est mal maîtrisée et induit des imprécisions importantes dans l'indication de la position courante du curseur et donc de la tige de commande. Ceci est incompatible avec la précision requise par la réglementation en matière d'inclinaison en zite d'un faisceau de projecteur (notamment d'un faisceau de croisement).

Une solution à ce problème est décrite dans le document US-A-4 500 866, qui correspond au préambule des revendications 1 et 6. Elle consiste à associer au potentiomètre un réseau de résistances discrètes reliées à la piste résistive du potentiomètre pour fixer avec une certaine précision le potentiel en certains points prédéterminés de celle-ci.

De cette manière, on corrige d'une façon économique la courbe de réponse du potentiomètre, soit pour la rendre suffisamment linéaire, soit encore pour que cette courbe passe par des points de passage obligés définis à la conception.

La présente invention a pour objet de simplifier encore un potentiomètre à piste corrigée de ce type, et en particulier de simplifier et de globaliser l'opération de dépôt de peinture résistive, tout en diminuant l'encombrement de la piste et de ses résistances discrètes, mais en ne compromettant pas la précision des contours de ces éléments.

Elle a aussi pour objet, en ayant recours ici encore à des moyens communs, de réaliser de façon beaucoup plus économique une couche de frottement du curseur résistant à l'abrasion.

Ainsi la présente invention propose tout d'abord un procédé de réalisation d'une partie d'un circuit électrique d'un dispositif de réglage de la position d'un organe mobile, notamment pour corriger l'orientation d'un faisceau de projecteur de véhicule automobile, tel qu'il est défini dans la revendication 1.

Des aspects préférés, mais non limitatifs, du procédé selon l'invention sont définis dans les revendications dépendantes 2 à 5.

Selon un second aspect, l'invention propose un circuit pour un dispositif de réglage de la position d'un organe mobile, notamment pour corriger l'orientation d'un faisceau de projecteur de véhicule automobile, tel qu'il est défini dans la revendication 6.

Des aspects préférés, mais non limitatifs, de ce circuit sont exposés dans les revendications dépendantes 7 à 10.

D'autres aspects, buts et avantages de la présente invention apparaîtront mieux à la lecture de la description détaillée suivante d'une forme de réalisation préférée de celle-ci, donnée à titre d'exemple et faite en référence au dessin annexé, sur lequel :
la figure 1 illustre un circuit imprimé d'un dispositif de réglage selon l'invention,
la figure 2 illustre une partie du schéma du circuit électrique réalisé à l'aide du circuit imprimé de la figure 1,
la figure 3a illustre une courbe de réponse défectueuse d'un potentiomètre de l'art antérieur,
la figure 3b illustre une courbe de réponse corrigée d'un potentiomètre réalisé selon l'invention, et
la figure 3c illustre une autre courbe de réponse corrigée d'un potentiomètre réalisé selon l'invention.

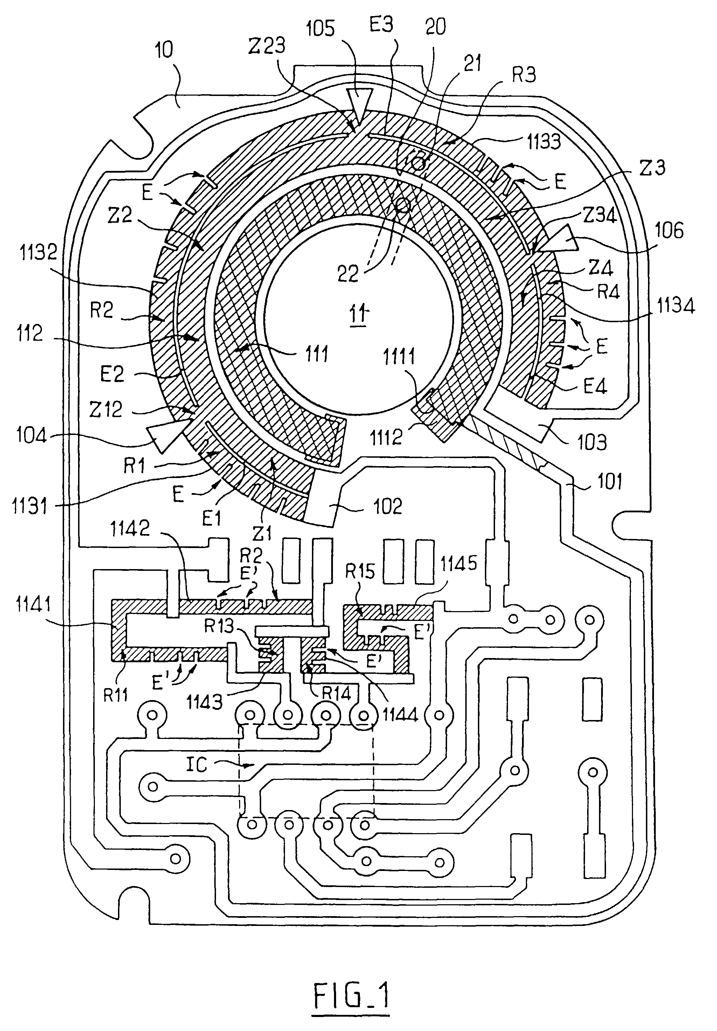

En référence maintenant à la figure 1, on a représenté un circuit imprimé destiné à être logé dans le boîtier (non représenté) d'un dispositif correcteur de l'orientation du faisceau d'un projecteur de véhicule automobile.

De façon classique en soi, le circuit imprimé comporte un substrat isolant 10 dans lequel est pratiquée une ouverture circulaire 11 traversée en son centre par la tige de sortie rotative (non représentée) du correcteur, entraînée par un moteur électrique, associé à un réducteur (également non représentés).

Sur cette tige est monté, solidaire en rotation avec elle, un curseur radial 20 comportant deux plots de contact 21 et 22.

Sur le circuit imprimé est formé un motif de pistes conductrices, réalisées conventionnellement par gravure de cuivre. L'on ne décrira pas en détail le tracé précis de ces pistes, l'homme du métier étant à même de concevoir le motif approprié en fonction de la répartition des composants.

Le circuit électrique monté sur ce circuit imprimé comprend, de façon classique en soi, une partie de lecture de la position angulaire du curseur 20 et donc de la tige de sortie du correcteur, et une partie de commnde du moteur d'entraînement de la tige.

Le curseur se déplace sur une piste annulaire intérieure, désignée par la référence 111, et sur une piste annulaire extérieure 112, coaxiale avec la piste 111. Les pistes 111 et 112 ont une étendue angulaire inférieure à 360°, et typiquement de l'ordre de 300° à 330°.

La piste intérieure 111 est reliée par une piste conductrice 101 au circuit de commande, en fournissant à ce dernier un signal de lecture de la position angulaire du curseur.

La piste extérieure 112 est une piste résistive continue exposée à une différence de potentiel appliquée entre des plots conducteurs d'extrémités 102 et 103 du circuit imprimé. De la sorte, la valeur de la tension du signal de mesure est représentatif de la position angulaire du curseur.

Cette piste extérieure 112 comporte quatre zones Z1 à Z4 s'étendant dans la continuité l'une de l'autre.

Il est prévu par ailleurs, à l'extérieur et le long de la piste 112, un jeu de quatre zones résistives calibrées 1131 à 1134 qui sont dans la continuité les unes des autres entre les plots conducteurs 102 et 103, c'est-à-dire constituant quatre résistances calibrées R1 à R4 branchées en série les unes avec les autres, et qui sont isolées de la piste résistive 112 par un ensemble de quatre zones étroites d'isolation E1 à E4. Ces quatres zones constituent un pont diviseur résistif.

Les zones d'isolation E1, E2 de première part, E2, E3 de seconde part, et E3, E4 de troisième part, définissent entre elles des zones de contact, respectivement Z12, Z23 et Z34, au niveau desquelles les régions de transition entre les zones Z1, Z2, Z3 et Z4 de la piste 112 et les régions de transition entre les résistances R1 à R4 sont reliées entre elles.

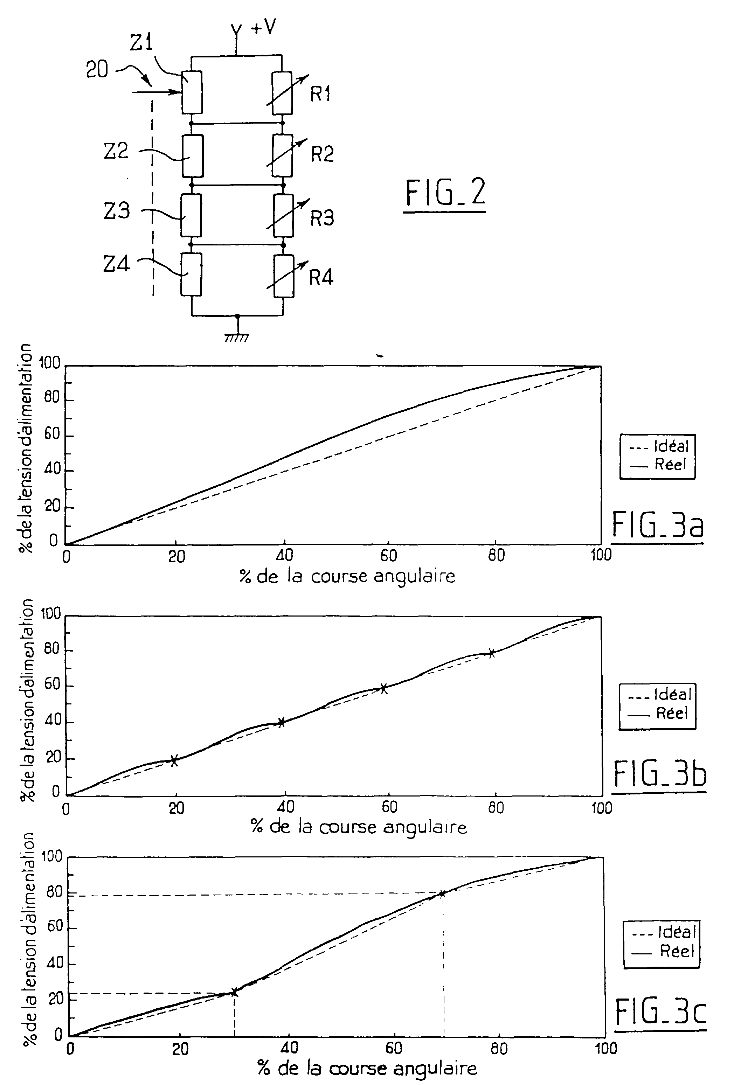

Le schéma électrique équivalent est illustré sur la figure 2.

Selon un aspect essentiel de l'invention, les différentes zones de la piste extérieure 112 ainsi que les zones résistives 1131 à 1134 sont réalisées par dépôt d'une peinture au carbone, par une technique de sérigraphie, de préférence au cours de la même étape.

Selon un autre aspect de l'invention, la piste résistive 112 et les zones résistives 1131 à 1134 sont initialement réunies les unes aux autres, et l'on utilise ensuite un découpage au rayon Laser pour créer des entailles étroites constituant les zones d'isolation E1 à E4.

On comprend que la précision de tracé inhérente à cette technologie permet de définir un positionnement extrêmement précis des zones Z12, Z23 et Z34 dans lesquelles la piste 112 et le pont diviseur constitué par les résistances R1 à R4 sont mis en contact mutuel.

Avantageusement, on utilise également cette technique de découpage au Laser pour former dans les différentes résistances R1 à R4 des entailles transversales, désignées par la référence E, destinées à calibrer d'une manière extrêmement précise la valeur ohmique de chacune de celles-ci.

Grâce à cet aspect de l'invention, les potentiels sur les positions angulaires de la piste extérieure 112 qui correspondent aux zones de liaison Z12, Z23 et Z34 peuvent être ajustés d'une façon extrêmement précise, et en même temps d'une façon tout à fait économique. En outre, toute modification souhaitée de la valeur ohmique des résistances peut être effectuée par simple programmation du trajet de l'outil de découpage au Laser.

De la sorte, il devient extrêmement aisé de prédéterminer la courbe de réponse du potentiomètre formé par les pistes 111 et 112 et par le curseur 20, en imposant des potentiels prédéterminés au droit des zones de liaison Z12, Z23 et Z34. A cet effet, on peut prévoir sur le circuit imprimé des plots conducteurs 104, 105 et 106, constitués par exemple par des zones de cuivre, s'étendant à la transition entre les résistances R1, R2, R3 et R4 et formant des points de mesure de tension pour la calibration précise desdites résistances.

A cet égard, la figure 3a des dessins montre une courbe, exprimant le pourcentage de la tension d'alimentation présent sur le curseur en fonction du pourcentage de la course angulaire de celui-ci, obtenue avec une piste résistive ordinaire de l'art antérieur. On observe sur cette figure que l'écart par rapport à une réponse linéaire (illustrée en tiretés) peut être substantiel, ce qui aboutit au fait que le curseur donne un signal de position erroné, et que la précision de l'ensemble du correcteur n'est pas satisfaisante.

La figure 3b montre la courbe de réponse obtenue en réglant les valeurs des résistances branchées en parallèle avec la piste résistive 112 de telle sorte qu'elle définissent des points de passage imposés de la courbe de réponse (représentés par des croix) qui se situent sur la droite représentant la linéarité.

Certes il peut exister, entre ces points, des écarts entre la réponse indiquée et une réponse parfaitement linéaire, mais ces écarts se trouvent considérablement diminués, et la précision du fonctionnement est grandement améliorée.

Enfin la figure 3c illustre le cas où les résistances branchées en parallèle avec la piste résistive 112 sont calibrées de manière à donner au potentiomètre une réponse volontairement non linéaire. Dans ce cas également, l'écart entre la position indiquée et la position théorique (définie par des droites réunissant les points de passage imposés) reste limité.

On observera ici que le circuit imprimé représenté sur la figure 1, en comportant quatre résistances R1 à R4, permet de fixer trois points de passage imposés. L'homme du métier comprendra aisément que l'exemple illustré sur la figure 3b, avec quatre points de passage imposés, sera réalisé avec cinq résistances, et que l'exemple illustré sur la figure 3c, avec deux points de passage imposés, sera réalisé avec trois résistances

On observera en outre que la largeur des séparations E1 à E4 entre la piste 112 et les résistances R1 à R4, ainsi que la largeur des entailles E formées dans ces résistances, ont été exagérées sur la figure 1 par souci de clarté. Dans la pratique, cette largeur est de quelques dizaines de microns.

Selon un autre aspect de la présente invention, la piste intérieure 111 du curseur est avantageusement constituée d'une piste de cuivre 1111 recouverte d'une couche 1112 de la même peinture au carbone que celle utilisée pour la piste extérieure 112 et pour les résistances 1131 à 1134. Ceci permet d'obtenir une piste qui présente une excellente résistance à l'abrasion, tout en étant beaucoup moins coûteuse à réaliser que les pistes conventionnellement traitées pour résister à l'abrasion à l'aide d'un revêtement de nickel ou d'or. En outre, la résistance électrique de contact induite par l'utilisation d'une peinture au carbone comme couche de frottement ne provoque pas de perturbation gênante dans le signal de mesure dans le cas où celui-ci attaque un étage comparateur à haute impédance du circuit de commande.

Selon un autre aspect intéressant de la présente invention, le circuit de commande est constitué par un circuit comparateur du commerce auquel peuvent être appliquées différentes tensions de seuil, par l'intermédiaire d'un circuit de commutation à semiconducteur (référence IC), également du commerce.

De tels circuits du commerce peuvent être utilisés dans la mesure où ils sont associés à un pont diviseur résistif dont les valeurs ohmiques des résistances discrètes sont suffisamment précises.

Ainsi il est particulièrement avantageux de réaliser les cinq résistances R11 à R15 constituant ce pont diviseur selon la même technique que les résistances R1 à R4. Ainsi, dans le présent exemple, ces résistances sont constituées par cinq zones 1141 à 1145 de dépôt sérigraphié de peinture au carbone, et des entailles E' sont formées par découpage au Laser pour en ajuster précisément la valeur ohmique.

Ainsi, c'est la conjonction d'une grande précision dans les potentiels présents sur les différentes zones de la piste extérieure 112 du curseur, et d'une grande précision dans les potentiels appliqués au comparateur du circuit de commande, qui permet d'utiliser un circuit comparateur du commerce, peu coûteux.

En conclusion, la présente invention permet de réaliser d'une façon extrêmement simple et économique un circuit électrique de commande asservie d'un dispositif de réglage à positions discrètes, tel qu'un correcteur d'orientation de faisceau d'un projecteur de véhicule automobile, et permet d'utiliser pour un tel dispositif des composants actifs du commerce.

Bien entendu, la présente invention n'est nullement limitée à la forme de réalisation décrite ci-dessus et représentée sur les dessins, mais l'homme du métier saura y apporter toute variante ou modification conforme à son esprit.

En particulier, bien que l'on ait décrit ci-dessus un circuit applicable à un correcteur à sortie rotative, l'homme du métier saura faire les adaptation nécessaires pour un correcteur à sortie linéaire.

En outre, les résistances correctrices R1 à R4 peuvent être placées en tout endroit approprié du circuit imprimé, et ne se trouvent pas nécessairement le long de la piste résistive 112.

Par ailleurs, on notera que l'implantation de résistances correctrices conformément à la présente invention pourra s'appliquer également à des correcteurs à structure de potentiomètre classique.

## Revendications

1. Procédé de réalisation d'une partie d'un circuit électrique d'un dispositif de réglage de la position d'un organe mobile, notamment pour corriger l'orientation d'un faisceau de projecteur de véhicule automobile, ladite partie de circuit comprenant un curseur (20) solidaire en déplacement avec l'organe mobile et une piste résistive continue (112) sur laquelle le curseur est apte à se déplacer avec contact électrique, une pluralité de résistances discrètes (R1-R4) étant reliées en parallèle avec ladite piste pour imposer certains potentiels en certains points de celle-ci, la piste résistive et les résistances discrètes étant réalisées par dépôt, caractérisé par les étapes consistant à déposer par sérigraphie sur un substrat une zone commune de peinture résistive constituant ladite piste (112) et lesdites résistances (1131-1134), et à séparer ladite piste et lesdites résistances les unes des autres par découpage au Laser dans ladite zone commune, de telle sorte que lesdites résistances s'étendent le long de ladite piste.

2. Procédé selon la revendication 1, où ladite partie de circuit comprend en outre une seconde piste (111) s'étendant le long de la première et destinée à établir un contact sensiblement non résistif avec le curseur (20), caractérisé en ce que ladite seconde piste comprend une zone métallique continue (1111) et en ce qu'au cours de l'étape de dépôt, on dépose également de la peinture résistive (1112) sur ladite zone métallique, de manière à réaliser une surface essentiellement non-résistive résistant à l'abrasion.

3. Procédé selon l'une des revendications 1 et 2, caractérisé par l'étape consistant à découper au Laser dans les zones définissant lesdites résistances discrètes des entailles (E) d'ajustement de la valeur ohmique desdites résistances discrètes.

4. Procédé selon l'une des revendications 1 à 3, où ladite partie de circuit comprenant en outre une série de résistances électriques discrètes (R11-R15) formant ponts diviseurs pour fixer des tensions de seuil à des fins de comparaison avec la tension recueillie par le curseur, caractérisé en ce qu'au cours de l'étape de dépôt, on forme sur le substrat des zones de peinture résistive (1141-1145) définissant lesdites résistances discrètes, et en ce qu'on découpe au Laser dans lesdites zones des entailles (E') d'ajustement de la valeur ohmique desdites résistances discrètes.

5. Procédé selon l'une des revendications 1 à 4, caractérisé en ce que ladite peinture résistive est une peinture au carbone.

6. Circuit pour un dispositif de réglage de la position d'un organe mobile, notamment pour corriger l'orientation d'un faisceau de projecteur de véhicule automobile, ledit circuit comportant un circuit imprimé (20) sur lequel sont déposées des pistes électriques (111, 112) aptes à coopérer avec un curseur (20) solidaire en mouvement de l'organe mobile, et une pluralité de résistances électriques discrètes (R1-R4) de fixation de potentiels également déposées sur le circuit imprimé, caractérisé en ce qu'au moins une piste résistive continue (112) et lesdites résistances sont constituées des zones localisées adjacentes (112, 1131-1134) de dépôt d'une peinture résistive, et en ce que les zones de dépôt localisé (1131-1134) qui constituent au moins certaines desdites résistances discrètes (R1-R4) sont séparées de la zone constituant ladite piste résistive continue par des interstices (E1-E4) de largeur essentiellement constante.

7. Circuit selon la revendication 6, caractérisé en ce que l'une (111) des pistes comprend une couche métallique (1111) revêtue d'une couche (1112) de ladite peinture résistive.

8. Circuit selon l'une des revendications 6 et 7, caractérisé en ce qu'au moins certaines des zones de dépôt localisé (1131-1134) constituant lesdites résistances discrètes (R1-R4) comportent des entailles (E) accroissant leur valeur ohmique.

9. Circuit selon les revendications 6 et 8 prises en combinaison, caractérisé en ce que lesdits interstices et lesdites entailles ont sensiblement même largeur.

10. Circuit selon l'une des revendications 6 à 9, caractérisé en ce que ladite peinture est une peinture au carbone.

## Patentansprüche

1. Verfahren zur Herstellung eines Teils eines elektrischen Stromkreises einer Vorrichtung zur Regelung der Position eines beweglichen Organs, insbesondere zur Korrektur der Neigung eines Lichtbündels eines Kraftfahrzeugscheinwerfers, wobei der besagte Stromkreisteil einen verschiebungsfest mit dem beweglichen Organ verbundenen Schleifer (20) und eine durchgehende Widerstandsbahn (112) umfaßt, auf der sich der Schleifer mit elektrischem Kontakt verschieben kann, wobei eine Mehrzahl von diskreten Widerständen (R1-R4) parallel mit der besagten Widerstandsbahn verbunden ist, um gewisse Potentiale an bestimmten Punkten dieser Bahn vorzugeben, wobei die Widerstandsbahn und die diskreten Widerstände durch Beschichtung ausgeführt sind, **gekennzeichnet** durch die Arbeitsschritte, die darin bestehen, mittels Siebdruck auf einer Isolierstoffplatte eine gemeinsame Widerstandsbeschichtungszone aufzubringen, die die besagte Widerstandsbahn (112) und die besagten Widerstände (1131-1134) bildet, und die besagte Widerstandsbahn und die besagten Widerstände durch Laserschneiden in der besagten gemeinsamen Zone voneinander zu trennen, so daß sich die besagten Widerstände entlang der besagten Widerstandsbahn erstrecken.

2. Verfahren nach Anspruch 1, wobei der besagte Stromkreisteil außerdem eine zweite Bahn (111) umfaßt, die sich entlang der ersten Bahn erstreckt und dazu bestimmt ist, einen im wesentlichen nicht-ohmschen Kontakt mit dem Schleifer (20) herzustellen, **dadurch gekennzeichnet**, daß die besagte zweite Bahn eine durchgehende Metallzone (1111) umfaßt und daß im Verlauf des Beschichtungsschritts außerdem eine Widerstandsbeschichtung (1112) auf der besagten Metallzone aufgebracht wird, um eine abriebfeste, im wesentlichen nicht-ohmsche Oberfläche auszuführen.

3. Verfahren nach einem der Ansprüche 1 und 2, **gekennzeichnet** durch den Arbeitsschritt, der darin besteht, in den Zonen, die die besagten diskreten Widerstände definieren, durch Laserschneiden Einschnitte (E) zur Einstellung des Ohmwerts der besagten Widerstände auszuführen.

4. Verfahren nach einem der Ansprüche 1 bis 3, wobei der besagte Stromkreisteil außerdem eine Reihe von diskreten elektrischen Widerständen (R11-R15) umfaßt, die Teilerbrücken bilden, um Schwellenspannungen zwecks Vergleich mit der durch den Schleifer aufgenommenen Spannung festzulegen, **dadurch gekennzeichnet**, daß im Verlauf des Beschichtungsschritts auf der Isolierstoffplatte Widerstandsbeschichtungszonen (1141-1145) gebildet werden, die die besagten diskreten Widerstände definieren, und daß in den besagten Zonen durch Laserschneiden Einschnitte (E') zur Einstellung des Ohmwerts der besagten diskreten Widerstände ausgeführt werden.

5. Verfahren nach einem der Ansprüche 1 bis 4, **dadurch gekennzeichnet**, daß die besagte Widerstandsbeschichtung eine Kohlenstoffbeschichtung ist.

6. Stromkreis für eine Vorrichtung zur Regelung der Position eines beweglichen Organs, insbesondere zur Korrektur der Neigung eines Lichtbündels eines Kraftfahrzeugscheinwerfers, wobei der besagte Stromkreis eine gedruckte Schaltung, auf der elektrische Bahnen (111, 112) aufgebracht sind, die mit einem bewegungsfest mit dem beweglichen Organ verbundenen Schleifer (20) zusammenwirken können, und eine Mehrzahl diskreter elektrischer Widerstände (R1-R4) zur Festlegung von Potentialen umfaßt, die ebenfalls auf der gedruckten Schaltung aufgebracht sind, **dadurch gekennzeichnet**, daß wenigstens eine durchgehende Widerstandsbahn (112) und die besagten Widerstände aus benachbarten lokalisierten Aufbringungszonen (112, 1131-1134) mit einer Widerstandsbeschichtung bestehen und daß die lokalisierten Aufbringungszonen (1131-1134), die wenigstens einige der besagten diskreten Widerstände (R1-R4) bilden, von der Zone, die die besagte durchgehende Widerstandsbahn bildet, durch Zwischenräume (E1-E4) mit einer im wesentlichen konstanten Breite getrennt sind.

7. Stromkreis nach Anspruch 6, **dadurch gekennzeichnet**, daß eine (111) der Bahnen eine Metallschicht (1111) umfaßt, die mit einer Schicht (1112) der besagten Widerstandsbeschichtung überzogen ist.

8. Stromkreis nach einem der Ansprüche 6 und 7, **dadurch gekennzeichnet**, daß wenigstens einige der lokalisierten Aufbringungszonen (1131-1134), die die besagten diskreten Widerstände (R1-R4) bilden, Einschnitte (E) umfassen, die ihren Ohmwert erhöhen.

9. Stromkreis nach den Ansprüchen 6 und 8 in Kombination, **dadurch gekennzeichnet**, daß die besagten Zwischenräume und die besagten Einschnitte in etwa die gleiche Breite haben.

10. Stromkreis nach einem der Ansprüche 6 bis 9, **dadurch gekennzeichnet**, daß die besagte Beschichtung eine Kohlenstoffbeschichtung ist.

## Claims

1. A method of making a part of an electrical circuit for a device for adjusting the position of a movable member, in particular for correcting the orientation of a motor vehicle headlight beam, the said circuit part comprising a cursor (20) fixed to the movable member for displacement therewith, and a continuous resistive track (112) on which the cursor is adapted to be displaced with electrical contact, a plurality of discrete resistors (R1-R4) being connected in parallel with the said track so as to impose certain potentials at certain points on the latter, the resistive track and the discrete resistors being formed by deposition, characterised by the steps which consist of depositing, by screen process printing on a substrate, a common zone of resistive coating constituting the said track (112) and the said resistors (1131-1134), and separating the said track and the said resistors from each other by laser cutting in the said common zone, in such a way that the said resistors extend along the said track.

2. A method according to Claim 1, in which the said circuit part further includes a second track (111) which extends along the first track and which is adapted to establish substantially non-resistive contact with the cursor (20), characterised in that the said second track includes a continuous metallic zone (1111), and in that, in the course of the deposition step, resistive paint (1112) is also deposited on the said metallic zone, whereby to produce an essentially non-resistive surface which is resistant to abrasion.

3. A method according to Claim 1 or Claim 2, characterised by the step that consists of cutting by laser, in the zones defining the said discrete resistors, notches (E) for adjusting the ohmic value of the said discrete resistors.

4. A method according to one of Claims 1 to 3, in which the said circuit part further includes a set of discrete electrical resistors (R11-R15) constituting divider bridges for fixing threshold voltages for the purpose of comparison with the voltage collected by the cursor, characterised in that, in the course of the deposition step, zones of resistive paint (1141-1145) defining the said discrete resistors are formed on the substrate, and in that notches (E') for adjustment of the ohmic value of the said discrete resistors are cut by laser in the said zones.

5. A method according to one of Claims 1 to 4, characterised in that the said resistive paint is a carbon paint.

6. A circuit for a device for regulating the position of a movable member, especially for correcting the orientation of a motor vehicle headlight beam, the said circuit comprising a printed circuit (20) on which electrical tracks (111, 112), adapted to cooperate with a cursor (20) and movable with the movable member, are deposited, and a plurality of discrete electrical resistors (R1-R4) for fixing potentials, which are also deposited on the printed circuit, characterised in that at least one continuous resistive track (112), and the said resistors, consist of adjacent local deposition zones (112, 1131-1134) of a resistive paint, and in that the localised deposition zones (1131-1134) that constitute at least some of the said discrete resistors (R1-R4) are separated by the zone constituting the said continuous resistive track by interstices (E1-E4) of essentially constant width.

7. A circuit according to Claim 6, characterised in that one (111) of the tracks comprises a metallic layer (1111) coated with a layer (1112) of the said resistive paint.

8. A circuit according to Claim 6 or Claim 7, characterised in that at least some of the localised deposition zones (1131-1134) constituting the said discrete resistors (R1-R4) include notches (E) increasing their ohmic value.

9. A circuit according to Claims 6 and 8 taken in combination, characterised in that the said interstices and the said notches have substantially the same width.

10. A circuit according to one of Claims 6 to 9, characterised in that the said paint is a carbon paint.
